# FASCICULE DE BREVET EUROPEEN

(11) **EP 3 772 753 B1**
(45) Date de publication et mention de la délivrance du brevet: **29.11.2023**
(21) Numéro de dépôt: 20189892.1
(22) Date de dépôt: 06.08.2020
(51) Int. Cl.: H01L 27/02

(54) **DISPOSITIF DE PROTECTION**
SCHUTZVORRICHTUNG
PROTECTION DEVICE

(30) Priorité: 09.08.2019 FR 1909122
(43) Date de publication de la demande: 10.02.2021
(73) Titulaire: STMicroelectronics (Tours) SAS, 37100 Tours (FR)
(72) Inventeur: ORY, Olivier, 37100 Tours (FR)
(74) Mandataire: Cabinet Beaumont

(56) Documents cités:
- US-A1- 2004 016 992
- US-A1- 2005 224 882
- US-A1- 2010 133 583
- US-A1- 2013 075 866
- US-A1- 2017 069 620

## Description

### Domaine technique

La présente description concerne de façon générale les dispositifs électroniques et, plus particulièrement, les dispositifs électroniques de protection contre les décharges électrostatiques.

### Technique antérieure

Des décharges électrostatiques (ElectroStatic Discharges - ESD) survenant dans un circuit intégré non protégé peuvent y produire des effets indésirables, qui conduisent la plupart du temps à une détérioration d'éléments constitutifs de ce circuit. Cette détérioration est souvent à l'origine de dysfonctionnements importants, susceptibles de rendre le circuit partiellement voire totalement inopérant.

Afin d'éviter les dégâts potentiellement causés par une décharge électrostatique, les circuits intégrés actuels comportent fréquemment des dispositifs de protection contre les effets de ces décharges électrostatiques. Pour être efficaces, ces dispositifs de protection doivent idéalement avoir :
une tension de déclenchement qui soit à la fois assez faible, pour protéger convenablement le circuit en cas de décharge électrostatique, mais aussi assez élevée, pour éviter tout déclenchement intempestif lors du fonctionnement normal du circuit ;
une tension de maintien, après déclenchement de la protection, qui soit suffisamment faible pour permettre d'exposer le circuit à une tension la plus basse possible tout en assurant une bonne dissipation du courant électrique issu de la décharge électrostatique ; et
une résistance dynamique qui soit la plus faible possible afin qu'une tension de blocage ou tension limite (clamping voltage), correspondant à la tension maximale pouvant être atteinte en cas de décharge électrostatique, soit la plus faible possible.

Les dispositifs de protection contre les décharges électrostatiques actuels ne permettent pas de concilier toutes les caractéristiques ci-dessus, ce qui affecte leurs performances.

Le document D1 (US 2013/075866) décrit un dispositif semiconducteur.

Le document D2 (US 2004/016992) décrit un dispositif de protection contre des décharges électrostatiques présentant une fiabilité et un contrôle de tension de déclenchement accrus.

Le document D3 (US 2010/133583) décrit un circuit intégré à semiconducteurs.

Le document D4 (US 2017/069620) décrit une structure de topographie de dispositif semiconducteur.

### Résumé de l'invention

Il existe un besoin d'améliorer les performances des dispositifs de protection contre les décharges électrostatiques actuels.

Un mode de réalisation pallie tout ou partie des inconvénients des dispositifs de protection contre les décharges électrostatiques connus.

L'invention concerne un dispositif tel que défini par la revendication indépendante 1. Des modes de réalisation préférés sont définis par les revendications dépendantes.

Selon un mode de réalisation, la région de base s'arrête avant le mur dans une deuxième direction perpendiculaire à la première direction.

Selon un mode de réalisation :
le substrat est d'un premier type de conductivité.

Selon un mode de réalisation, la région de base pénètre à l'intérieur du mur sur une distance comprise entre environ 20 % et environ 50 % de la longueur de la région de base dans la première direction, de préférence sur une distance comprise entre 20 % et 50 % de la longueur de la région de base dans la première direction.

Selon un mode de réalisation, la région de base se prolonge à l'intérieur du mur sur une distance d'environ 30 % de la longueur de la région de base dans la première direction, de préférence sur une distance égale à 30 % de la longueur de la région de base dans la première direction.

Selon un mode de réalisation, le premier type de conductivité est p et le deuxième type de conductivité est n.

Selon un mode de réalisation, le premier type de conductivité est n et le deuxième type de conductivité est p.

Selon un mode de réalisation :
des premières pistes de reprise de contact sont situées à l'aplomb des zones de collecteur ; et
des deuxièmes pistes de reprise de contact sont situées à l'aplomb des zones d'émetteur.

Un mode de réalisation prévoit un dispositif de protection contre des décharges électrostatiques comprenant au moins un dispositif électronique tel que décrit précédemment.

Selon un mode de réalisation, le dispositif possède une tension de maintien supérieure à 5 V et une tension de blocage inférieure à 7 V.

Selon un mode de réalisation, le dispositif est adapté à protéger une application dont une tension limite est comprise entre environ 0 V et environ 5 V, de préférence entre 0 V et 5 V.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, de façon schématique, une vue de dessus d'un mode de réalisation d'un dispositif électronique ;
la figure 2 représente, de façon schématique, une vue en perspective et en coupe selon le plan AA de la figure 1 ;
la figure 3 représente, de façon schématique, une vue en perspective et en coupe selon le plan BB de la figure 1 ;
la figure 4 représente un circuit électrique équivalent au mode de réalisation du dispositif exposé en relation avec les figures 1 à 3 ; et
la figure 5 représente une caractéristique courant-tension d'un mode de réalisation d'un dispositif de protection contre les décharges électrostatiques.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les composants ou circuits intégrés à protéger contre les décharges électrostatiques ne seront pas décrits, ces composants ou circuits intégrés étant compatibles avec les composants ou circuits traditionnellement protégés contre les décharges électrostatiques.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

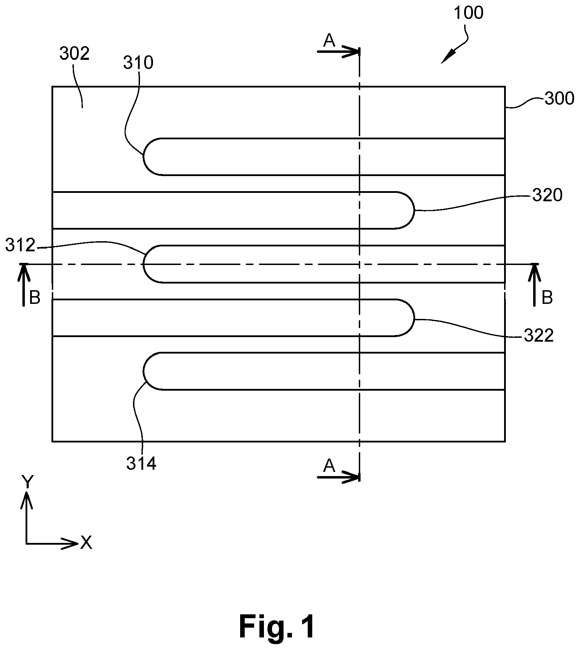

La figure 1 représente, de façon schématique, une vue de dessus d'un mode de réalisation d'un dispositif électronique 100.

Ce dispositif 100 intègre, dans un substrat 300, un ou plusieurs transistors latéraux parallèles entre eux. La figure 1 est une vue de dessus illustrant la répartition de pistes conductrices de reprise de contact de régions de collecteur et d'émetteur de ces transistors.

Selon ce mode de réalisation, le dispositif 100 est réalisé dans tout ou partie du substrat 300. Le substrat 300 est, par exemple, une plaquette (wafer) de silicium dont seule une portion de forme rectangulaire a été représentée en figure 1. Ce substrat 300 (ou cette portion de substrat 300) comporte, en surface supérieure 302, une structure interdigitée.

En figure 1, cette structure interdigitée se compose :
de premiers doigts 310, 312 et 314, sensiblement parallèles entre eux, s'étendant selon une première direction X en surface supérieure 302 du substrat 300 depuis un premier côté du substrat 300 (le côté droit, en figure 1) ; et
de deuxièmes doigts 320 et 322, sensiblement parallèles entre eux, s'étendant selon la première direction X en surface supérieure 302 du substrat 300 depuis un deuxième côté du substrat 300 (le côté gauche, en figure 1). Ce deuxième côté est, dans cet exemple, le côté opposé au premier côté, de sorte que les premiers et deuxièmes doigts 310, 312, 314, 320 et 322 sont sensiblement parallèles entre eux.

Les premiers doigts 310, 312 et 314 constituent les pistes de reprise de contact de premières régions (par exemple, des régions de collecteur des transistors). Les deuxièmes doigts constituent les pistes de reprise de contact de deuxièmes régions (par exemple, des régions d'émetteur des transistors).

En d'autres termes, la structure interdigitée est ici constituée de deux « peignes », l'un formé des premiers doigts 310, 312 et 314 et l'autre formé des deuxièmes doigts 320 et 322, qui s'interpénètrent. La structure interdigitée comporte ainsi, le long d'une deuxième direction Y perpendiculaire à la première direction X, une alternance de premiers et de deuxièmes doigts. En d'autres termes, deux premiers doigts voisins, respectivement deux deuxièmes doigts voisins, sont séparés par un deuxième doigt, respectivement par un premier doigt.

Les premiers et deuxièmes doigts 310, 312, 314, 320 et 322 sont espacés les uns des autres. Autrement dit, les doigts 310, 312, 314, 320 et 322 ne sont pas jointifs.

Pour simplifier, dans l'exemple de la figure 1, seuls cinq doigts (trois premiers doigts 310, 312, 314 et deux deuxièmes doigts 320, 322) ont été représentés. Le substrat 300 peut néanmoins comporter plusieurs autres premiers et deuxièmes doigts intercalés, toujours dans l'exemple de la figure 1, entre le premier doigt 312 et le deuxième doigt 322.

Le substrat 300 peut ainsi comporter un nombre quelconque de premiers doigts et un nombre quelconque de deuxièmes doigts. Ces nombres de premiers et de deuxièmes doigts peuvent être différents. Le substrat 300 peut, par exemple, comporter huit premiers doigts et sept deuxièmes doigts.

Le substrat 300 comporte, de préférence, au moins deux premiers doigts et au moins un deuxième doigt. En figure 1, on a représenté un substrat 300 comportant un nombre impair de premiers doigts et un nombre pair de deuxièmes doigts. Toutefois, en pratique, le substrat 300 peut indifféremment comporter des nombres pairs ou impairs de premiers et de deuxièmes doigts.

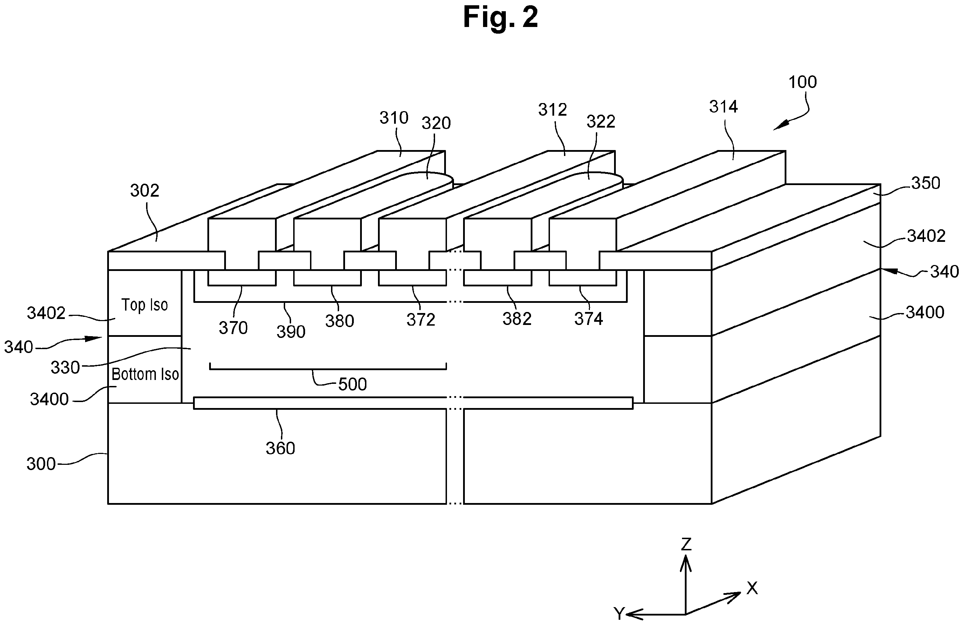

La figure 2 représente, de façon schématique, une vue en perspective et en coupe selon le plan AA de la figure 1. Ce plan de coupe AA est perpendiculaire à la direction X des premiers et deuxièmes doigts 310, 312, 314, 320 et 322 (c'est-à-dire parallèle à la direction Y).

En figure 2, le substrat 300 comporte, sous sa surface supérieure 302, un caisson 330. Ce caisson 330 est délimité latéralement par un mur 340 d'isolation périphérique. Dans la vue en coupe de la figure 2, seules les parois de ce mur 340 d'isolation qui sont parallèles à l'axe X sont visibles. Le mur 340 d'isolation comporte, dans cet exemple, une première zone 3400 (Bottom Iso) et une deuxième zone 3402 (Top Iso) superposées dans une troisième direction (Z) verticale.

Le substrat 300 est constitué d'un matériau d'un premier type de conductivité, par exemple du silicium monocristallin dopé de type p. Le mur 340 d'isolation périphérique est du même type de conductivité que ce substrat 300, ici du type p. Toujours dans cet exemple, la première zone 3400 est formée à partir d'une couche enterrée de type p. La deuxième zone 3402 est formée à partir d'une autre couche, de type p également.

En variante, le caisson 330 possède une épaisseur sensiblement égale à celle de la deuxième zone 3402 et le mur 340 ne comporte alors que cette deuxième zone 3402.

Le caisson 330 est réalisé, de préférence, par épitaxie (par croissance épitaxiale) d'un matériau dopé d'un deuxième type de conductivité, différent du premier type de conductivité. Ce caisson 330 est constitué, par exemple, de silicium dopé de type n. Le caisson 330 est ainsi d'un type de conductivité différent :
du type de conductivité du substrat 300 ; et
du type de conductivité du mur 340.

Le substrat 300 est passivé en surface et comporte ainsi, en figure 2, une couche 350 de passivation superficielle. La surface supérieure 302 du substrat 300 correspond donc, dans cet exemple, à la surface supérieure de sa couche 350 de passivation.

En figure 2, une troisième zone 360 est formée à l'interface entre la partie inférieure du caisson 330 et le substrat 300. Cette troisième zone 360 s'étend le long de la direction Y et s'arrête avant le mur 340 d'isolation périphérique. Dans cet exemple, la zone 360 est formée à partir d'une couche enterrée de type n.

Des premières régions 370, 372 et 374 et des deuxièmes régions 380 et 382 sont formées sous la couche 350 de passivation du substrat 300. Ces premières et deuxièmes régions 370, 372, 374, 380 et 382 sont parallèles entre elles, non jointives, et s'étendent le long de la première direction X. Dans l'exemple de la figure 2 :
les premières régions 370, 372 et 374 sont respectivement situées à l'aplomb des premiers doigts 310, 312 et 314 ; et
les deuxièmes régions 380 et 382 sont respectivement situées à l'aplomb des deuxièmes doigts 320 et 322.

Les premiers doigts 310, 312 et 314 traversent la couche 350 de passivation du substrat 300 pour venir contacter respectivement les premières régions 370, 372 et 374. De la même façon, les deuxièmes doigts 320 et 322 traversent la couche 350 de passivation du substrat 300 pour venir contacter respectivement les deuxièmes régions 380 et 382.

En figure 2, une troisième région 390 s'étend sous les premières régions 370, 372 et 374 et sous les deuxièmes régions 380 et 382, depuis la couche 350 de passivation du substrat 300. Cette troisième région 390 s'arrête, dans la deuxième direction Y, avant le mur 340 d'isolation périphérique.

Les premières régions 370, 372 et 374 et les deuxièmes régions 380 et 382 sont du même type de conductivité que le caisson 330, dans cet exemple du type n. La troisième région 390 est du même type de conductivité que le substrat 300, dans cet exemple du type p.

La troisième région 390 forme ainsi, avec les premières régions 370, 372 et 374 et les deuxièmes régions 380 et 382, des jonctions p-n. En figure 2, les premières régions 370 et 372, la deuxième région 380 et la troisième région 390 forment conjointement un transistor 500 latéral, ici de type NPN, également appelé transistor latéral NPN 500. Dans cet exemple :
les premières régions 370 et 372 constituent des régions de collecteur du transistor 500 ;
la deuxième région 380 constitue une région d'émetteur du transistor 500 ;
la troisième région 390 constitue une région de base du transistor 500 ; et
la première région 374 et la deuxième région 382 constituent respectivement une région de collecteur et une région d'émetteur d'un autre transistor latéral NPN semblable au transistor 500 et partiellement représenté en figure 2.

Les premiers doigts 310 et 312, respectivement connectés aux régions de collecteur 370 et 372, constituent ainsi des contacts de collecteur du transistor latéral NPN 500. Le deuxième doigt 320, connecté à la région d'émetteur 380, constitue un contact d'émetteur du transistor latéral NPN 500. La région de base 390 n'étant connectée à aucune piste de reprise de contact, elle est qualifiée de « base flottante » du transistor 500.

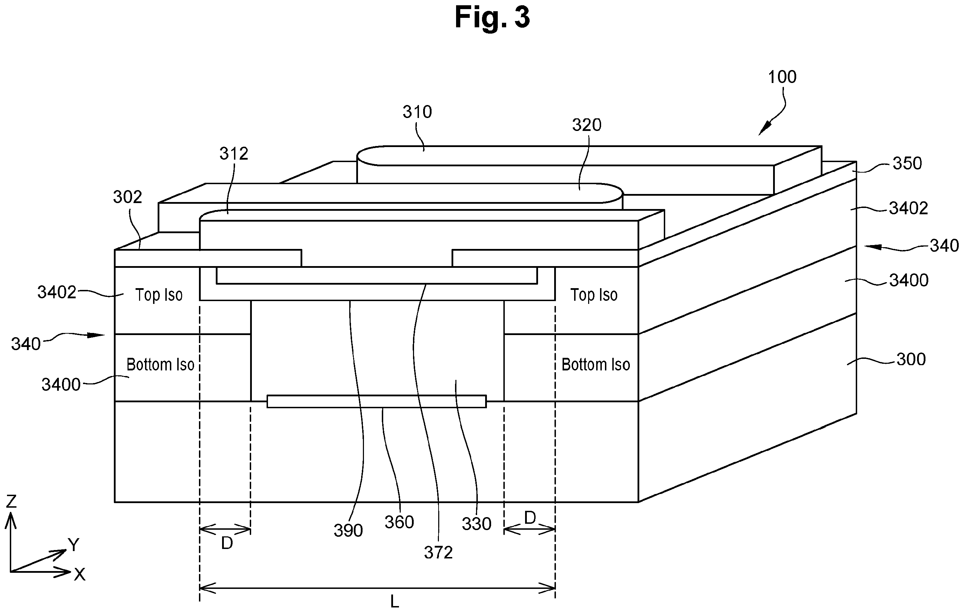

La figure 3 représente, de façon schématique, une vue en perspective et en coupe selon le plan BB de la figure 1. Ce plan de coupe BB est parallèle à la direction X des premiers et deuxièmes doigts 310, 312, 314, 320 et 322 (c'est-à-dire perpendiculaire à la direction Y). En figure 3, seuls le premier doigt 310, le deuxième doigt 320 et une partie du premier doigt 312 sont visibles, le plan BB (figure 1) coupant approximativement le substrat 300 au milieu du premier doigt 312.

En figure 3, le caisson 330 est toujours délimité latéralement par le mur 340 d'isolation périphérique. Dans la vue en coupe de la figure 3, seules les parois de ce mur 340 d'isolation qui sont parallèles à l'axe Y sont visibles. Le mur 340 d'isolation comporte toujours, dans cet exemple, la première zone 3400 (Bottom Iso) et la deuxième zone 3402 (Top Iso) superposées.

La troisième zone 360 s'étend le long de la direction X et s'arrête avant le mur 340 d'isolation périphérique.

Selon ce mode de réalisation, le mur 340 est élargi, dans la première direction X parallèle aux régions 370, 372 et 374 de collecteur et aux régions 380 et 382 d'émetteur (seule la région 372 de collecteur est visible dans la vue en coupe de la figure 3), de sorte que la région 390 de base pénètre à l'intérieur du mur 340.

En figure 3, la région 390 de base pénètre à l'intérieur du mur 340 sur une distance, notée D, comprise entre environ 20 % et environ 50 % de la longueur, notée L, de la région 390 de base dans la première direction X, de préférence sur une distance D comprise entre 20 % et 50 % de la longueur L de la région 390 dans la première direction X. La région 390 de base se prolonge, plus préférentiellement, à l'intérieur du mur 340 sur une distance D d'environ 30 % de la longueur L de la région 390 de base dans la première direction X, encore plus préférentiellement sur une distance D égale à 30 % de la longueur L de la région 390 dans la première direction X.

En variante, la région 390 de base pénètre uniquement dans la deuxième zone 3402 du mur 340. La première zone 3400 peut, le cas échéant, posséder une largeur inférieure à la largeur de la deuxième zone 3402, ces largeurs étant toutes deux évaluées le long de la première direction X.

Un dispositif 100 comportant un ou plusieurs transistors semblables au transistor latéral NPN 500 peut être utilisé pour protéger au moins un circuit intégré et/ou au moins un composant électronique discret contre des décharges électrostatiques. Le dispositif 100 est, par exemple, adapté à protéger des circuits d'entrée-sortie contre des décharges électrostatiques pouvant survenir à leurs bornes.

Pour protéger un ou plusieurs circuits d'entrée-sortie comportant chacun une borne mise à un potentiel de référence (par exemple, la masse), noté GND, et une autre borne portée à un potentiel non nul, noté IO, on relie ou on connecte par exemple :
les contacts 310, 312 de collecteur du transistor 500 à la borne portée au potentiel IO ; et
le contact 320 d'émetteur du transistor 500 à la borne mise à la masse GND.

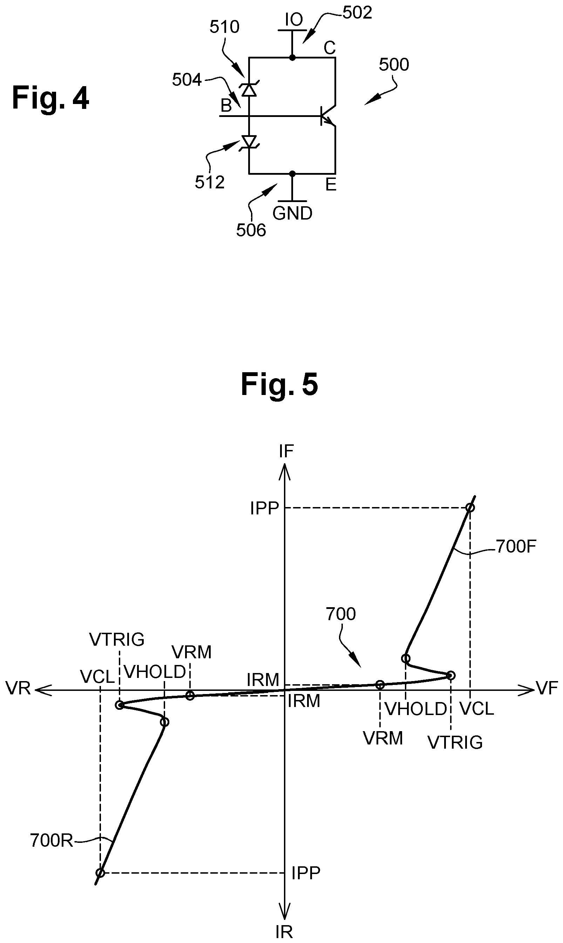

La figure 4 représente un circuit électrique équivalent au mode de réalisation du dispositif 100 exposé en relation avec les figures 1 à 3.

Par la suite, on considère pour simplifier que le dispositif 100 ne comporte qu'un seul transistor latéral NPN 500 comme exposé en relation avec les figures 2 et 3. Ce transistor 500 du dispositif 100 possède, dans le circuit électrique équivalent de la figure 4 :
une borne 502 (C) de collecteur ;
une base 504 (B) flottante ; et
une borne 506 (E) d'émetteur.

Selon le mode de réalisation exposé en relation avec les figures 2 et 3 :
la borne 502 de collecteur du transistor 500 est, par exemple, constituée par les pistes 310 et 312 de reprise de contact connectées aux premières régions 370 et 372 de collecteur ;
la base flottante 504 du transistor 500 est, par exemple, constituée par la région 390 de base ; et
la borne 506 d'émetteur du transistor 500 est, par exemple, constituée par la piste 320 de reprise de contact connectée à la deuxième région 380 d'émetteur.

Le transistor 500 du dispositif 100 comporte également, comme illustré en figure 4 :
une première diode Zener 510 dont l'anode est connectée à la base flottante 504 du transistor 500 et dont la cathode est connectée à la borne 502 de collecteur du transistor 500 ; et
une deuxième diode Zener 512 dont l'anode est connectée à la base flottante 504 du transistor 500 et dont la cathode est connectée à la borne 506 d'émetteur du transistor 500.

Dans l'exemple d'un dispositif 100 adapté à protéger un ou plusieurs circuits d'entrée-sortie contre des décharges électrostatiques :
la borne 502 de collecteur du transistor 500 est connectée à une borne d'entrée-sortie (IO) du ou des circuits à protéger ; et
la borne 506 d'émetteur du transistor 500 est mise à la masse GND.

La figure 5 représente une caractéristique courant-tension d'un mode de réalisation d'un dispositif de protection contre les décharges électrostatiques, par exemple un dispositif 100 comportant au moins un transistor latéral NPN 500. La caractéristique courant-tension de la figure 5 correspond, par exemple, au circuit équivalent exposé en relation avec la figure 4.

Une courbe 700 traduit, en figure 5, une variation d'intensité d'un courant électrique direct, noté IF, ou inverse, noté IR, parcourant le transistor latéral NPN 500. Cette intensité est fonction d'une tension de polarisation directe, notée VF, ou d'une tension de polarisation inverse, notée VR.

La courbe 700 est ainsi, en figure 5, divisée en deux portions :
une portion 700F (à droite, en figure 5) correspondant à des variations du courant direct IF en fonction de la tension de polarisation directe VF ; et
une portion 700R (à gauche, en figure 5) correspondant à des variations du courant inverse IR en fonction de la tension de polarisation inverse VR.

Les portions 700F et 700R de la courbe 700 sont, au signe près, sensiblement identiques. Pour simplifier, seule la portion 700F sera décrite par la suite, la transposition de cette description à la portion 700R de la courbe 700 étant à la portée de l'homme du métier à partir des indications ci-dessous.

En fonctionnement normal, la tension de polarisation directe VF du dispositif 100 peut prendre des valeurs comprises entre 0 V et une tension limite, notée VRM. Cette tension limite VRM correspond à la valeur de tension maximale prévue pour une application donnée. La tension limite VRM est, par exemple, de l'ordre de 3 V ou de 5 V, selon l'application considérée. Lorsque le transistor 500 est polarisé sous cette tension limite VRM, un courant de fuite, noté IRM, traverse ce transistor 500.

En cas de surtension due, par exemple, à une décharge électrostatique, la tension de polarisation VF peut temporairement excéder une tension de seuil, notée VTRIG. Cette tension de seuil VTRIG correspond à une tension de déclenchement de la protection. Afin d'éviter tout risque de déclenchement intempestif de cette protection, on fait en sorte que la tension de seuil VTRIG soit supérieure à la tension limite VRM prévue dans l'application considérée.

Une fois la tension de seuil VTRIG dépassée, c'est-à-dire une fois la protection déclenchée, un phénomène de retournement (snap-back effect) se produit. Ce phénomène de retournement provoque une baisse significative de la tension de polarisation aux bornes du transistor 500. Après retournement, la tension de polarisation VF peut ainsi décroître jusqu'à une valeur de tension minimale, appelée « tension de maintien », notée VHOLD. En d'autres termes, la tension de maintien VHOLD correspond à la tension minimale pouvant être atteinte après déclenchement de la protection.

Le phénomène de retournement permet au transistor 500 d'évacuer un courant électrique sensiblement supérieur au courant qui le traverserait, avant retournement, sous une tension de même valeur. En d'autres termes, ce phénomène de retournement permet au transistor 500 de véhiculer un courant important tout en limitant l'augmentation de tension (la surtension temporaire) causée par la décharge électrostatique. En limitant ainsi l'augmentation de tension, on diminue les risques de détérioration d'un ou plusieurs circuits et/ou composants protégés par le transistor 500.

La décharge électrostatique peut néanmoins être suffisamment importante pour que la tension de polarisation directe VF du transistor 500 continue à augmenter même après le déclenchement de la protection. Cette augmentation de la tension VF s'accompagne d'une augmentation du courant IF traversant le transistor 500. Ce courant IF, qui traverse le transistor 500, est alors sensiblement proportionnel à la tension de polarisation directe VF selon une relation du type IF = VF/RDYN, où RDYN est appelée « résistance dynamique » de la protection.

Comme illustré en figure 5, la valeur de la tension de polarisation directe VF peut alors augmenter jusqu'à une valeur, notée VCL, appelée tension de blocage (clamping voltage) . Cette tension de blocage VCL correspond à un maximum d'intensité acceptable par la protection (peak pulse current), noté IPP.

Pour certaines applications, on cherche à obtenir une tension de maintien VHOLD supérieure à la tension limite VRM. Les inventeurs ont constaté qu'il était possible de modifier la valeur de cette tension de maintien VHOLD en ajustant des niveaux de dopage des régions de base et des régions d'émetteur du transistor 500. En particulier, les inventeurs se sont aperçus qu'une augmentation du niveau de dopage des régions de base et d'émetteur du transistor 500 entraînait une baisse de la tension de maintien VHOLD.

Pour un transistor 500 dont la région 390 de base pénètre à l'intérieur du mur 340 d'isolation périphérique (figure 3), les inventeurs ont en outre constaté qu'il était possible d'abaisser la tension de déclenchement VTRIG sans dégrader la qualité de la protection. Cette diminution de la tension de déclenchement VTRIG signifie que la protection est plus rapide et plus réactive. La diminution de la tension de déclenchement VTRIG permet en outre de réduire la tension de blocage VCL résiduelle vue par l'application avant l'activation complète de la structure. En d'autres termes, les inventeurs se sont aperçus qu'il était possible d'obtenir une protection plus sensible tout en améliorant la valeur de sa résistance dynamique RDYN, le dispositif 100 possédant une résistance série améliorée du fait de la présence de deux diodes Zener 510 et 512 (figure 4) en parallèle.

Comme exposé en relation avec la figure 3, une région de base se prolongeant à l'intérieur du mur 340 sur une distance D d'environ 30 % de la longueur L de la région 390 de base dans la première direction X permet, en particulier, d'obtenir une réduction de la tension de blocage VCL d'environ 8,5 % pour un même courant IF. En d'autres termes, le transistor 500 est capable, sous une même tension VF, de véhiculer un courant IF plus important qu'un transistor dont la région 390 de base ne pénétrerait pas à l'intérieur du mur 340 d'isolation périphérique.

Un dispositif de protection contre des décharges électrostatiques, comprenant au moins un dispositif 100 tel qu'exposé précédemment en relation avec les figures 1 à 3, permet en particulier d'obtenir une tension de maintien VHOLD supérieure à 5 V tout en conservant une tension de blocage VCL inférieure à 7 V. Un tel dispositif de protection est ainsi compatible avec des applications pour lesquelles la tension limite VRM est comprise entre environ 0 V et environ 5 V, de préférence entre 0 V et 5 V. On obtient la valeur de la tension de maintien VHOLD souhaitée grâce à la présence des deux diodes Zener 510 et 512 (figure 4).

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art. En particulier, ce qui a été précédemment décrit en relation avec les figures 1 à 5 prend pour exemple un mode de réalisation d'un dispositif 100 comportant au moins un transistor latéral 500 de type NPN. Toutefois, les types de conductivité (les dopages) pris pour exemple dans la présente description peuvent être inversés. En particulier, l'adaptation de ce mode de réalisation à un dispositif 100 comportant au moins un transistor latéral de type PNP est à la portée de l'homme du métier à partir des indications fournies ci-dessus.

Enfin, la mise en œuvre pratique des modes de réalisation et variantes décrits est à la portée de l'homme du métier à partir des indications fonctionnelles données ci-dessus. En particulier, le raccordement (ou la connexion) des pistes de reprise de contact du ou des transistors 500 que comporte le dispositif 100 aux bornes du ou des circuits et/ou du ou des composants discrets à protéger est à la portée de l'homme du métier à partir des indications ci-dessus. Par ailleurs, on pourra prévoir que le substrat 300 soit d'un type de conductivité quelconque. Toutefois, le mur 340 et la région de base 390 sont d'un type de conductivité différent de celui du caisson 330, des régions de collecteur 370, 372 et de la région d'émetteur 380. Plus particulièrement, l'isolation du caisson 330 par des jonctions de type différent sert à l'isolation entre différents composants sur une même puce. Le transistor étant localisé au niveau des zones 390, 370 et 380, l'espèce du substrat n'intervient pas dans le comportement normal de la structure. Par exemple, le substrat peut être de type identique à celui du caisson 330. Si le substrat 300 est du même type de conductivité que le caisson 330, la zone enterrée 360 n'est alors plus nécessaire. Le type de conductivité du mur 340 est cependant identique à celui de la base 390 du transistor. Le dopage sera toutefois différent afin d'obtenir un effet Zener localisé.

## Revendications

1. Dispositif électronique (100) comprenant un substrat (300) comportant :
un caisson (330) ;
un mur (340) d'isolation périphérique, entourant le caisson (330) ; et
au moins un transistor (500) bipolaire latéral, réalisé dans le caisson (330), dont une région (390) de base s'étend sous des régions (370, 372, 374, 380, 382) de collecteur et d'émetteur parallèles entre elles,
le mur (340) étant élargi dans une première direction (X), parallèle aux régions (370, 372, 374, 380, 382) de collecteur et d'émetteur, de sorte que la région (390) de base pénètre à l'intérieur du mur (340), dans lequel :
le mur (340) est d'un premier type de conductivité ;
la région de base (390) est du premier type de conductivité ;
le caisson (330) est d'un deuxième type de conductivité, différent du premier type de conductivité ; et
les régions (370, 372, 374, 380, 382) de collecteur et d'émetteur sont du deuxième type de conductivité.

2. Dispositif selon la revendication 1, dans lequel la région (390) de base s'arrête avant le mur (340) dans une deuxième direction (Y) perpendiculaire à la première direction (X).

3. Dispositif selon la revendication 1 ou 2, dans lequel le substrat (300) est du premier type de conductivité.

4. Dispositif selon l'une quelconque des revendications 1 à 3, dans lequel la région (390) de base pénètre à l'intérieur du mur (340) sur une distance (D) comprise entre environ 20 % et environ 50 % de la longueur (L) de la région (390) de base dans la première direction (X), de préférence sur une distance (D) comprise entre 20 % et 50 % de la longueur (L) de la région (390) de base dans la première direction (X) .

5. Dispositif selon l'une quelconque des revendications 1 à 4, dans lequel la région (390) de base se prolonge à l'intérieur du mur (340) sur une distance (D) d'environ 30 % de la longueur (L) de la région (390) de base dans la première direction (X), de préférence sur une distance (D) égale à 30 % de la longueur (L) de la région (390) de base dans la première direction (X).

6. Dispositif selon l'une quelconque des revendications 1 à 5, dans lequel le premier type de conductivité est p et le deuxième type de conductivité est n.

7. Dispositif selon l'une quelconque des revendications 1 à 5, dans lequel le premier type de conductivité est n et le deuxième type de conductivité est p.

8. Dispositif selon l'une quelconque des revendications 1 à 7, dans lequel :
des premières pistes (310, 312, 314) de reprise de contact sont situées à l'aplomb des zones (370, 372, 374) de collecteur ; et
des deuxièmes pistes (320, 322) de reprise de contact sont situées à l'aplomb des zones (380, 382) d'émetteur.

9. Dispositif de protection contre des décharges électrostatiques comprenant au moins un dispositif électronique (100) selon l'une quelconque des revendications 1 à 8.

10. Dispositif selon la revendication 9, possédant une tension de maintien (VHOLD) supérieure à 5 V et une tension de blocage (VCL) inférieure à 7 V.

11. Dispositif selon la revendication 9 ou 10, adapté à protéger une application dont une tension limite (VRM) est comprise entre environ 0 V et environ 5 V, de préférence entre 0 V et 5 V.

## Patentansprüche

1. Elektronische Vorrichtung (100) mit einem Substrat (300), wobei die Vorrichtung Folgendes aufweist:
eine Wanne (330);
eine periphere isolierende Wand (340), die die Wanne (330) umgibt; und
mindestens einen lateralen Bipolartransistor (500), der in der Wanne (330) ausgebildet ist und einen Basisbereich (390) aufweist, der sich unter parallelen Kollektor- und Emitterbereichen (370, 372, 374, 380, 382) erstreckt,
wobei die Wand (340) in einer ersten Richtung (X) parallel zu den Kollektor- und Emitterbereichen (370, 372, 374, 380, 382) erweitert ist, so dass der Basisbereich (390) in die Wand (340) eindringt, wobei:
die Wand (340) einen ersten Leitfähigkeitstyp aufweist;
der Basisbereich (390) den ersten Leitfähigkeitstyp aufweist;
die Wanne (330) einen zweiten Leitfähigkeitstyp aufweist, der sich von dem ersten Leitfähigkeitstyp unterscheidet; und
die Kollektor- und Emitterbereiche (370, 372, 374, 380, 382) den zweiten Leitfähigkeitstyp aufweisen.

2. Vorrichtung nach Anspruch 1, wobei der Basisbereich (390) vor der Wand (340) in einer zweiten Richtung (Y) senkrecht zur ersten Richtung (X) endet.

3. Vorrichtung nach Anspruch 1 oder 2, wobei das Substrat (300) den ersten Leitfähigkeitstyp aufweist.

4. Vorrichtung nach einem der Ansprüche 1 bis 3, wobei der Basisbereich (390) über eine Strecke (D) im Bereich von etwa 20% bis etwa 50% der Länge (L) des Basisbereichs (390) in der ersten Richtung (X) in die Wand (340) eindringt, vorzugsweise über eine Strecke (D) im Bereich von 20% bis 50% der Länge (L) des Basisbereichs (390) in der ersten Richtung (X).

5. Vorrichtung nach einem der Ansprüche 1 bis 4, wobei sich der Basisbereich (390) über eine Strecke (D) von etwa 30% der Länge (L) des Basisbereichs (390) in der ersten Richtung (X) in die Wand (340) fortsetzt, vorzugsweise über eine Strecke (D) gleich 30% der Länge (L) des Basisbereichs (390) in der ersten Richtung (X).

6. Vorrichtung nach einem der Ansprüche 1 bis 5, wobei der erste Leitfähigkeitstyp p und der zweite Leitfähigkeitstyp n ist.

7. Vorrichtung nach einem der Ansprüche 1 bis 5, wobei der erste Leitfähigkeitstyp n und der zweite Leitfähigkeitstyp p ist.

8. Vorrichtung nach einem der Ansprüche 1 bis 7, wobei:
erste Kontaktbahnen (310, 312, 314) vertikal in Reihe mit den Kollektorbereichen (370, 372, 374) angeordnet sind; und
zweite Kontaktbahnen (320, 322) vertikal in Reihe mit den Emitterbereichen (380, 382) angeordnet sind.

9. Vorrichtung zum Schutz gegen elektrostatische Entladungen mit mindestens einer elektronischen Vorrichtung (100) nach einem der Ansprüche 1 bis 8.

10. Vorrichtung nach Anspruch 9, mit einer Haltespannung (VHOLD) von mehr als 5 V und einer Klemmspannung (VCL) von weniger als 7 V.

11. Vorrichtung nach Anspruch 9 oder 10, die zum Schutz einer Anwendung geeignet ist, bei der eine Grenzspannung (VRM) zwischen etwa 0 V und etwa 5 V, vorzugsweise zwischen 0 V und 5 V, liegt.

## Claims

1. An electronic device (100) comprising a substrate (300) comprising:
a well (330);
a peripheral insulating wall (340) surrounding the well (330); and
at least one lateral bipolar transistor (500) formed in the well (330), having a base region (390) extending under parallel collector and emitter regions (370, 372, 374, 380, 382),
the wall (340) being widened in a first direction (X), parallel to the collector and emitter regions (370, 372, 374, 380, 382), so that the base region (390) penetrates into the wall (340), wherein:
the wall (340) has a first conductivity type;
the base region (390) has the first conductivity type;
the well (330) has a second conductivity type different from the first conductivity type; and
the collector and emitter regions (370, 372, 374, 380, 382) have the second conductivity type.

2. The device of claim 1, wherein the base region (390) stops before the wall (340) in a second direction (Y) perpendicular to the first direction (X).

3. The device of claim 1 or 2, wherein the substrate (300) has the first conductivity type.

4. The device of any of claims 1 to 3, wherein the base region (390) penetrates into the wall (340) over a distance (D) in the range from approximately 20% to approximately 50% of the length (L) of the base region (390) in the first direction (X), preferably over a distance (D) in the range from 20% to 50% of the length (L) of the base region (390) in the first direction (X).

5. The device of any of claims 1 to 4, wherein the base region (390) continues into the wall (340) over a distance (D) of approximately 30% of the length (L) of the base region (390) in the first direction (X), preferably over a distance (D) equal to 30% of the length (L) of the base region (390) in the first direction (X).

6. The device of any of claims 1 to 5, wherein the first conductivity type is p and the second conductivity type is n.

7. The device of any of claims 1 to 5, wherein the first conductivity type is n and the second conductivity type is p.

8. The device of any of claims 1 to 7, wherein:
first contacting tracks (310, 312, 314) are located vertically in line with the collector areas (370, 372, 374); and
second contacting tracks (320, 322) are located vertically in line with the emitter areas (380, 382).

9. A device of protection against electrostatic discharges comprising at least one electronic device (100) of any of claims 1 to 8.

10. The device of claim 9, having a holding voltage (VHOLD) greater than 5 V and a clamping voltage (VCL) of less than 7 V.

11. The device of claim 9 or 10, suitable for protecting an application for which a limit voltage (VRM) is between about 0 V and about 5 V, preferably between 0 V and 5 V.
